# FASCICULE DE BREVET EUROPEEN

(11) **EP 3 138 199 B1**
(45) Date de publication et mention de la délivrance du brevet: **13.06.2018**
(21) Numéro de dépôt: 15718970.5
(22) Date de dépôt: 24.03.2015
(51) Int. Cl.: H03K 19/0185, H03K 19/003, G06F 1/30, H04L 25/02, H01L 27/02, G06F 13/40, G11C 5/06

(54) **INTERFACE DE COMMUNICATION AVEC ADAPTATION AUTOMATIQUE AU NIVEAU DU SIGNAL ENTRANT**
KOMMUNIKATIONSSCHNITTSTELLE MIT AUTOMATISCHER ANPASSUNG DES PEGELS DES EINGANGSSIGNALS
COMMUNICATION INTERFACE WITH AUTOMATIC ADAPTATION OF THE LEVEL OF THE INPUT SIGNAL

(30) Priorité: 30.04.2014 FR 1453923
(43) Date de publication de la demande: 08.03.2017
(73) Titulaire: WISeKey Semiconductors, 13590 Meyreuil (FR)
(72) Inventeur: RUDOLFF, François, F-13090 Aix En Provence (FR); ROCHE, Julien, F-13200 Arles (FR)
(74) Mandataire: de Jong, Jean Jacques
(86) Numéro de dépôt international: PCT/FR2015/050732
(87) Numéro de publication internationale: WO 2015/166151

(56) Documents cités:
- EP-A1- 0 471 399
- EP-A1- 1 231 563
- US-A1- 2004 027 153
- US-A1- 2005 267 728
- US-A1- 2008 043 390
- US-B1- 8 698 543

## Description

### Domaine technique

L'invention est relative aux interfaces de communication servant à relier entre eux des appareils ou des circuits individuels, notamment aux interfaces série bidirectionnelles comme I2C, USB, IEEE-1394, HDMI, SWP, SPI, etc.

### Arrière-plan

Le document US8698543 décrit une interface dans un dispositif électronique couplé à un bus de communication série. Le document US2008/0043390 décrit un circuit de protection contre les décharges électrostatiques pour protéger un circuit interne contre les surtensions.

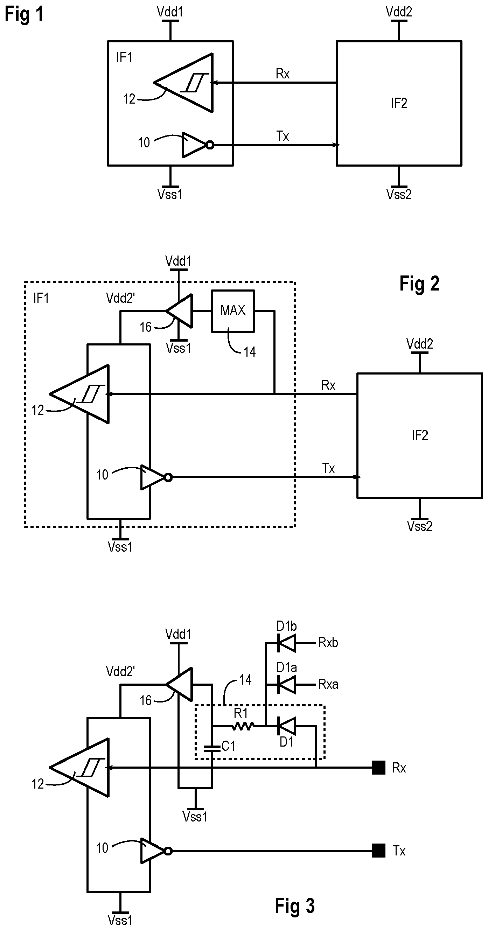

La figure 1 représente schématiquement une configuration où deux interfaces IF1 et IF2 sont connectées par une liaison série bidirectionnelle. Les notations et définitions ci-après sont fournies en référence à l'interface IF1 ou interface « locale », l'interface IF2 étant l'interface « distante ».

Toute liaison série bidirectionnelle comprend généralement une ligne de réception Rx, une ligne d'émission Tx, et une ligne de masse (non-représentée). Selon les normes ou protocoles des interfaces, d'autres lignes peuvent être prévues, comme une ligne d'horloge, des lignes de gestion de flux, etc.

Le signal sortant sur la ligne Tx est fourni par un amplificateur 10, couramment désigné par le terme anglais « buffer », souvent sous la forme d'un inverseur. Le signal entrant sur la ligne Rx est traité par un discriminateur de niveaux logiques 12, par exemple un comparateur à hystérésis ou « trigger de Schmitt ». Les éléments 10 et 12 de l'interface sont adaptés aux spécifications de la norme de communication utilisée. Toute norme spécifie notamment une tension crête à crête des signaux et des fréquences de fonctionnement. Les valeurs de tension sont fournies avec une marge de tolérance. L'interface locale IF1 est alimentée entre une masse Vss1 et un potentiel Vddl, tandis que l'interface distante IF2 est alimentée entre une masse Vss2 et un potentiel Vdd2. Les masses Vss1 et Vss2 sont généralement mises au même niveau par la ligne de masse, non-représentée, de la liaison série. Les potentiels d'alimentation Vddl et Vdd2 peuvent être différents.

Dans de nombreux cas, les deux interfaces IF1 et IF2 sont conçues spécifiquement pour utiliser le même protocole de communication. Si les potentiels Vddl et Vdd2 ne correspondent pas au niveau de tension requis par le protocole, les interfaces peuvent intégrer des régulateurs de tension qui alimentent les éléments 10 et 12 des interfaces avec le niveau de tension requis. Ainsi, chaque inverseur 10 fournit un signal logique ayant l'excursion requise, même si le signal à son entrée présente une excursion différente, et chaque discriminateur 12 établit ses seuils de commutation aux mêmes niveaux, de sorte que les interfaces homologues se comportent de manière cohérente entre elles, et soient le cas échéant conformes à la norme utilisée.

La cohérence des interfaces homologues dépend donc de la qualité de l'appariement entre les niveaux d'alimentation de ces interfaces. Même si les normes préconisent des niveaux de tension avec une marge de tolérance, le respect de ces marges n'est pas toujours garanti.

On souhaite ainsi que les interfaces homologues fonctionnent ensemble de manière satisfaisante même si les tensions d'alimentation des interfaces varient dans des proportions inconnues. Le brevet US 8 698 543 et la demande de brevet EP 1231563 proposent une solution satisfaisant ce besoin.

La figure 2 représente une interface locale IF1, telle que décrite dans la demande de brevet EP 1231563, capable de s'adapter automatiquement aux conditions de fonctionnement de l'interface distante IF2.

L'interface IF1 comprend des éléments d'une interface classique, notamment l'amplificateur ou inverseur 10 fournissant le signal sortant Tx et le discriminateur de niveaux logiques 12 traitant le signal entrant Rx.

L'interface IF1 comprend en outre un détecteur de crête 14 connecté pour mémoriser le niveau crête du signal entrant Rx. Le niveau de crête Vdd2' établi par le circuit 14 est répliqué à basse impédance par un suiveur de tension 16. La sortie du suiveur 16 alimente le côté haut des éléments 10 et 12 de l'interface, dont le côté bas est alimenté par la ligne de masse Vss1.

Avec cette configuration, dès que le signal entrant Rx présente un niveau haut, qui correspond en principe au niveau d'alimentation Vdd2 de l'interface distante IF2, les éléments 14 et 16 établissent la tension d'alimentation des éléments 10 et 12 à ce même niveau, ou à un niveau proche noté Vdd2'. Ainsi, les seuils de comparaison du discriminateur 12 s'établissent naturellement à des valeurs adaptées au signal d'entrée Rx, et l'inverseur 10 produit un signal sortant Tx ayant une excursion adaptée à l'interface distante. Ce fonctionnement est obtenu quelle que soit la tension d'alimentation de l'interface distante ou l'excursion du signal entrant Tx. Il en résulte que l'interface locale s'adapte automatiquement au niveau d'alimentation de l'interface distante.

Dans certaines applications, notamment si les interfaces n'ont pas besoin d'être rapides, l'inverseur 10 est un simple transistor MOS à canal N monté en « drain ouvert ». En d'autres termes, ce transistor n'est pas alimenté du côté haut (Vdd2') dans l'interface locale - l'interface distante comprend un résistance, dite « pull-up », qui relie la ligne Tx au potentiel d'alimentation Vdd2.

Le détecteur de crête utilisé dans ces circuits comprend généralement un circuit RC et une diode, éléments qui peuvent occuper une surface silicium non négligeable dans certaines applications.

### Résumé

On prévoit une interface de communication, selon la revendication 1. L'interface de communication comprend une borne d'entrée conçue pour recevoir un signal logique d'une interface distante ; un discriminateur de niveaux logiques couplé à la borne d'entrée ; un détecteur de crête connecté pour mémoriser la valeur crête du signal sur la borne d'entrée ; et un suiveur de tension connecté pour fournir au discriminateur une tension d'alimentation auxiliaire basée sur la valeur fournie par le détecteur de crête. L'interface inclut un dispositif de protection contre les décharges électrostatiques, comprenant une première diode et un circuit RC formant le détecteur de crête, connectés en série entre la borne d'entrée et une première ligne d'alimentation ; un transistor connecté entre la première ligne d'alimentation et la borne d'entrée par la première diode ou une deuxième diode ; et un inverseur configuré pour rendre conducteur le transistor lorsque la tension aux bornes du condensateur du circuit RC est inférieure à un seuil.

L'interface peut comprendre en outre une borne de sortie conçue pour fournir un signal logique sortant à l'interface distante ; et un amplificateur connecté pour commander la borne de sortie à partir de la tension d'alimentation auxiliaire.

L'interface peut comprendre un empilement de diodes connecté aux bornes du condensateur.

L'interface peut comprendre en outre un élévateur de tension configuré pour alimenter le suiveur de tension à une tension supérieure à la tension d'alimentation de l'interface. L'interface peut comprendre un atténuateur commutable connecté entre la borne d'entrée et le discriminateur ; et un comparateur connecté pour mettre l'atténuateur en circuit lorsque la tension d'alimentation de l'interface est inférieure à la valeur crête fournie par le détecteur de crête.

### Description sommaire des dessins

Des modes de réalisation seront exposés dans la description suivante, faite à titre non limitatif en relation avec les figures jointes parmi lesquelles :
- la figure 1, précédemment décrite, représente schématiquement une configuration où deux interfaces sont connectées par une liaison série bidirectionnelle ;
- la figure 2, précédemment décrite, représente schématiquement une interface locale capable de s'adapter automatiquement au niveau de tension d'un signal série fourni par une interface distante ;
- la figure 3 représente un exemple de détecteur de crête utilisable dans l'interface locale de la figure 2 ;
- la figure 4 représente schématiquement un exemple de dispositif de protection contre les décharges électrostatiques d'une borne d'un circuit intégré ;
- la figure 5 illustre un mode de réalisation d'une interface locale exploitant le dispositif de protection de la figure 4 pour réaliser un détecteur de crête ;
- la figure 6 représente une variante de l'interface locale de la figure 5 ;
- la figure 7 représente une variante de l'interface locale de la figure 2 ; et
- la figure 8 représente une autre variante de l'interface locale de la figure 2.

### Description de modes de réalisation

La figure 3 représente un exemple de détecteur de crête 14 utilisable dans l'interface locale IF1 de la figure 2. Ce détecteur comprend un circuit RC formé d'un condensateur C1 et d'une résistance R1 connectés en série. La valeur crête fournie au suiveur 16 est prélevée sur le point de connexion entre la résistance et le condensateur. Le condensateur C1 est par ailleurs relié à la ligne de masse Vss1. La résistance R1 est par ailleurs reliée à une borne de connexion de la ligne Rx par une diode D1 orientée dans le sens passant pour les valeurs positives du signal Rx par rapport à la masse Vss1.

Avec cette configuration, le condensateur C1 se charge à la valeur crête du signal Rx, diminuée de la tension seuil de la diode D1. Lorsque le niveau du signal Rx décroît, la diode D1 se bloque, de sorte que le condensateur C1 conserve la tension maximale atteinte.

Ainsi, le niveau fourni par le détecteur de crête 14 diffère du niveau d'alimentation Vdd2 de l'interface distante par un seuil de diode. Le seuil de la diode D1 étant déterminable localement, le suiveur 16 peut être conçu pour le compenser, ou bien les éléments 10 et 12 peuvent être conçus pour en tenir compte.

Le détecteur de crête 14 et le suiveur 16 de la figure 3 peuvent être partagés par plusieurs interfaces réalisées dans le même circuit, lorsque ces interfaces utilisent sensiblement la même excursion pour leurs signaux d'entrée/sortie. Pour cela, comme cela est représenté pour deux signaux entrants supplémentaires Rxa et Rxb, chaque signal entrant est appliqué sur l'anode d'une diode respective D1a, D1b. Les cathodes de ces diodes sont connectées à la même résistance R1. Les éléments 10 et 12 de chaque interface sont alors alimentés par le même suiveur 16.

Le détecteur de crête 14 présente une certaine impédance sur la ligne Rx. Il est souhaitable que cette impédance affecte peu les caractéristiques de la ligne Rx. Pour cela, la résistance R1 peut être choisie avec une valeur plutôt élevée et/ou le condensateur C1 choisi avec une valeur plutôt faible. Les valeurs de résistance et de capacité peuvent être choisies pour satisfaire à la fois une charge suffisamment rapide du condensateur à la valeur crête, une impédance suffisamment élevée pour ne pas affecter les caractéristiques de la ligne Rx, et le maintien de la charge du condensateur pendant que le signal Rx est au niveau bas entre deux passages par un niveau haut.

Si les contraintes évoquées ci-dessus quant au choix des valeurs de capacité et de résistance s'avèrent difficiles à satisfaire dans certains cas, on pourra utiliser une autre structure de détecteur de crête, dont un exemple est présenté plus loin.

Par contre, la structure à diode et circuit RC de la figure 3 peut faire partie intégrante d'un dispositif de protection contre les décharges électrostatiques prévu à l'origine dans l'interface, et donc n'occuper aucune surface de silicium supplémentaire.

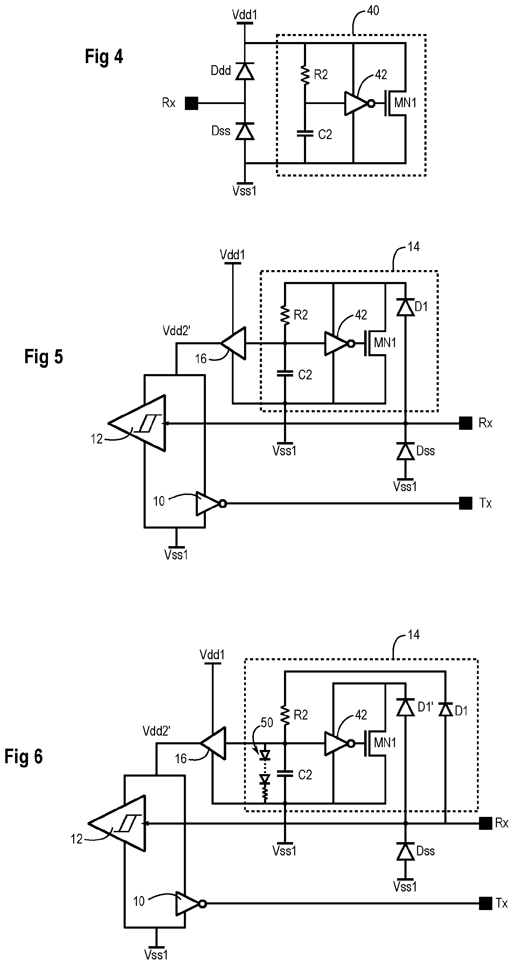

La figure 4 représente schématiquement un exemple de dispositif de protection contre les décharges électrostatiques que l'on peut utiliser dans une interface de communication. Chaque borne du circuit, comme la borne dédiée au signal entrant Rx, est reliée aux lignes d'alimentation Vddl, Vss1 par des diodes respectives Ddd, Dss connectées en inverse. Une cellule de protection 40 comprend un transistor MOS à canal N MN1 relié pour court-circuiter les lignes d'alimentation Vddl et Vss1. La grille du transistor MN1 est commandée par un inverseur 42. L'inverseur 42 est commandé par le point milieu d'un circuit RC formé d'un condensateur C2 relié à la masse Vss1 et d'une résistance R2 reliée à la ligne d'alimentation Vddl.

En pratique, plusieurs cellules de protection 40 sont distribuées dans le circuit à protéger pour partager l'absorption des décharges. Souvent une cellule 40 est prévue à proximité de chaque borne du circuit.

Lorsque les bornes du circuit sont en l'air, une impulsion de décharge électrostatique se produisant entre deux bornes quelconques est redressée par les diodes Ddd et Dss correspondantes et appliquée sur les lignes d'alimentation Vddl et Vss1. Le condensateur C2 étant initialement déchargé, la tension à ses bornes est nulle. L'inverseur 42, qui se trouve alimenté par l'impulsion, voit un niveau logique 0 à son entrée et applique un niveau logique 1 sur la grille du transistor MN1. Le transistor MN1 est rendu conducteur et tend à court-circuiter les lignes Vddl et Vss1 entre elles. Le transistor MN1 absorbe le courant de la décharge et s'oppose à une augmentation du niveau de tension entre les lignes Vddl et Vss1. La constante de temps du circuit RC est choisie pour que l'impulsion n'ait pas le temps de charger le condensateur C2 à un niveau suffisant pour faire commuter l'inverseur 42.

Lorsque le circuit est alimenté normalement, la tension appliquée entre les lignes Vddl et Vss1 est constante et finit par charger le condensateur C2. L'inverseur 42 voit alors un niveau logique 1 et bloque le transistor MN1.

En pratique, le temps de montée de la tension d'alimentation est beaucoup plus long que le temps de montée d'une impulsion de décharge électrostatique. La constante de temps du circuit RC peut être choisie suffisamment rapide pour que la tension aux bornes du condensateur C2 suive l'évolution de la tension d'alimentation en restant toujours au-dessus du seuil de commutation de l'inverseur 42. Dans ce cas, l'inverseur 42 ne rend pas conducteur le transistor MN1 pendant la mise sous tension et celui-ci ne dérive aucun courant.

La figure 5 illustre une intégration du dispositif de protection de la figure 4 dans un détecteur de crête de l'interface de la figure 3. Cette configuration permet de partager le circuit RC du détecteur de crête avec le dispositif de protection, et ainsi de ne pas occuper de la surface silicium supplémentaire pour la réalisation du circuit RC.

La cellule de protection 40 de la figure 4 est intégralement reproduite à la figure 5. Cependant, la cellule n'est plus reliée à la ligne d'alimentation Vddl. Au lieu de cela, la cellule est alimentée par la diode D1 du détecteur de crête de la figure 3, qui remplace la diode Ddd de la figure 4. Le circuit RC R2/C2 joue le même rôle que le circuit RC du détecteur de crête de la figure 3. Ainsi, son point milieu est relié à l'entrée du suiveur 16.

Le dispositif de protection joue toujours son rôle lorsque les bornes du circuit sont en l'air. Une impulsion appliquée entre la borne Rx et la masse Vss1 traverse le dispositif de protection comme elle le ferait dans le cas de la figure 4, en passant par la diode D1 et le transistor MN1. En fait le dispositif de protection n'est plus mutualisé avec des dispositifs homologues - il peut être commun aux bornes Rx et Tx.

A la mise sous tension normale, le dispositif de protection n'étant pas relié à la ligne d'alimentation Vddl, le condensateur C2 reste déchargé. Le condensateur se charge lorsque la borne Rx reçoit un signal entrant. Le signal entrant présente également un temps de montée lent par rapport à une décharge électrostatique. Il en résulte que le transistor MN1 reste bloqué et n'affecte pas l'évolution du signal entrant. A titre d'exemple, dans le cadre de la norme I2C ou ISO-7816, on peut avoir une constante de temps RC = 834 ns, avec R2 = 657 kOhm et C2 = 1,27 pF.

La figure 6 représente une variante de l'interface de la figure 5. Le circuit RC et la diode D1 sont découplés du reste du dispositif de protection. Le reste du dispositif de protection est relié à la borne Rx par une diode indépendante Dl'. Avec cette configuration, tout en préservant le même fonctionnement que le circuit de la figure 5, la diode D1 peut être significativement plus petite que la diode Dl'. En effet, la diode D1 ne voit plus un courant important en cas de décharge électrostatique, le courant de la décharge passant par la diode Dl'. Cela permet d'augmenter l'impédance de la diode D1 et donc de diminuer l'effet du détecteur de crête sur le signal entrant Rx.

La figure 6 représente en outre un limiteur de tension 50 connecté aux bornes du condensateur C2. Un rôle du limiteur 50 est de protéger le condensateur C2, l'inverseur 42 et le suiveur 16 de surtensions pouvant être appliquées sur la borne Rx. L'élément 50 comprend, par exemple, un empilement de diodes dont les cathodes sont orientées vers la masse Vss1. Cet empilement définit la tension limite par la somme des tensions de jonction des diodes.

Si on considère les schémas électriques en théorie, il n'y a pas de chemin de décharge du condensateur C2 si la tension à ses bornes est inférieure à celle définie par le limiteur 50. Il est souhaitable que ce condensateur se décharge. En pratique, le condensateur C2 serait déchargé par des courants de fuite liés à la technologie de fabrication. La vitesse de décharge est difficile à maîtriser dans cette situation. Il n'est pas envisageable d'utiliser une résistance de valeur élevée aux bornes du condensateur, car elle occuperait une surface trop importante. En fait l'empilement 50 offre un moyen de décharge lente maîtrisable par les courants de fuite des jonctions polarisées en direct des diodes. L'empilement peut être complété par une résistance série de valeur raisonnable, comme cela est représenté, si la vitesse de décharge à travers les diodes s'avère trop rapide.

Les modes de réalisation qui viennent d'être décrits visent un détecteur de crête dont la structure, à base d'un circuit RC et d'une diode, peut être partagée avec d'autres éléments. Comme on l'a précédemment évoqué, cette structure peut ne pas être adaptée à toutes les situations, du fait de la chute de tension produite aux bornes de la diode et de l'impédance présentée par la structure sur la ligne Rx.

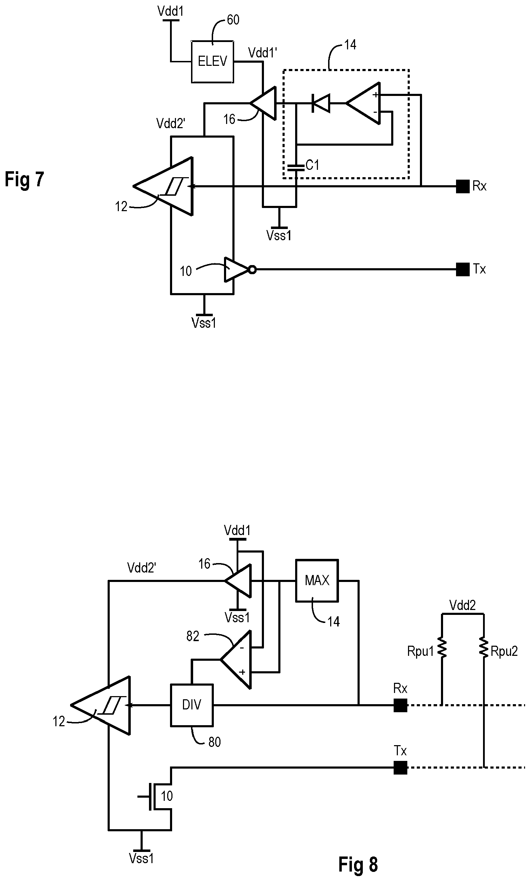

La figure 7 représente un mode de réalisation d'interface auto-adaptative avec une variante de détecteur de crête pouvant éviter ces difficultés. Le détecteur de crête 14 est réalisé à partir d'un amplificateur opérationnel monté en redresseur mono-alternance suivi du condensateur C1. Un tel détecteur de crête présente une impédance d'entrée élevée et réplique la tension crête sans chute de tension.

Par ailleurs, afin de pouvoir alimenter les éléments 10 et 12 par une tension Vdd2' a priori inconnue, provenant de la détection de crête sur un signal externe, il convient qu'une tension supérieure ou égale à Vdd2' soit disponible à l'intérieur de l'interface locale. Pour satisfaire toutes les situations possibles, l'interface locale peut être conçue pour fonctionner avec une tension d'alimentation Vddl égale à la tension maximale de la gamme de tensions utilisées dans les interfaces de communication.

Cependant, si on souhaite néanmoins alimenter l'interface locale avec une tension Vddl plutôt basse dans la gamme, on peut prévoir un circuit élévateur de tension 60, par exemple une pompe de charges, qui alimente le suiveur 16 et les éléments actifs du détecteur de crête 14 par une tension Vdd1' supérieure à la valeur crête attendue du signal entrant.

Les interfaces utilisant des sorties en drain ouvert, comme on l'a précédemment évoqué, ne sont pas contraignantes quant à l'excursion du signal, si l'excursion peut être réglée par une résistance de « pull-up » du côté de l'interface réceptrice. Dans certaines applications, notamment si une même ligne de transmission est reliée aux entrées de plusieurs interfaces, on prévoit une seule résistance de « pull-up » pour la ligne, qui peut être une résistance externe aux interfaces, reliée à un niveau de tension indépendant des interfaces. Ce niveau de tension indépendant, que l'on désignera par Vdd2 dans ce contexte, peut être supérieur à la tension d'alimentation Vddl de l'interface locale considérée.

La figure 8 représente un mode de réalisation d'interface permettant de traiter cette situation sans utiliser l'élévateur de tension 60 de la figure 7. L'amplificateur de sortie 10 est formé d'un transistor connecté en drain ouvert à la borne Tx. On suppose que chacune des lignes Rx et Tx est reliée, en externe, à un niveau de tension Vdd2 par une résistance « pull-up » respective Rpu1 et Rpu2.

Si la tension Vdd2 est supérieure au niveau d'alimentation Vddl de l'interface locale, le discriminateur 12 peut, dans certains cas, ne plus détecter de niveau logique bas dans le signal entrant Rx, en particulier lorsque le signal Rx est aux limites tolérées par les normes pour représenter un niveau logique bas.

Pour éviter cette situation, la borne Rx est reliée à l'entrée du discriminateur 12 par un atténuateur commutable 80. Un comparateur 82 est connecté pour commander l'atténuateur 80 en fonction de la différence entre le niveau crête enregistré par le détecteur 14 et la tension d'alimentation locale Vddl.

Si la tension crête est inférieure à la tension Vddl, l'atténuateur 80 est commuté pour n'appliquer aucune atténuation. Le discriminateur 12 est alimenté à une tension Vdd2' correspondant à la valeur crête enregistrée, comme dans le cas de la figure 2.

Si la tension crête est supérieure à la tension Vddl, le suiveur 16 sature et alimente le discriminateur 12 à la tension Vddl. L'atténuateur 80 est alors commuté pour appliquer une atténuation. La valeur de l'atténuation est de préférence égale à Vdd1/Vdd2, pour que l'excursion nominale du signal entrant soit ramenée à Vddl sans distorsion. Cependant, la valeur Vdd2 n'est pas connue à l'avance. La valeur de l'atténuation peut être choisie à une valeur moyenne compte tenu des possibilités discrètes des valeurs des tensions Vddl et Vdd2. L'atténuation n'a pas besoin d'être précise - il suffit qu'elle permette au discriminateur 12 de détecter un niveau logique bas dans le signal entrant selon les marges permises par les normes.

Une interface auto-adaptative du type décrit dans la présente demande peut être particulièrement utile dans un contexte où plusieurs circuits intégrés montés sur un circuit imprimé ou carte-mère communiquent entre eux par des interfaces série. Dans ce cas, on prévoit souvent un circuit « maître » qui possède plusieurs interfaces pour communiquer en parallèle avec plusieurs circuits « esclaves ». Les interfaces du circuit maître peuvent alors être auto-adaptatives, alors que les interfaces des circuits esclaves peuvent être classiques voire parfois non-maitrisés par le fabriquant du circuit maître.

## Revendications

1. Interface de communication, comprenant :
• une borne d'entrée (Rx) conçue pour recevoir un signal logique d'une interface distante (IF2) ;
• un discriminateur de niveaux logiques (12) couplé à la borne d'entrée ;un détecteur de crête (14) connecté pour mémoriser la valeur crête du signal sur la borne d'entrée ; et
• un suiveur de tension (16) connecté pour fournir au discriminateur une tension d'alimentation auxiliaire (Vdd2') basée sur la valeur fournie par le détecteur de crête ;
**caractérisée en ce qu'**elle comprend un dispositif de protection contre les décharges électrostatiques, comprenant :
• une première diode (D1) et un circuit RC formant le détecteur de crête, connectés en série entre la borne d'entrée (Rx) et une première ligne d'alimentation (Vss1) ;
• un transistor (MN1) connecté entre la première ligne d'alimentation (Vss1) et la borne d'entrée (Rx) par la première diode (D1) ou une deuxième diode (D1') ; et
• un inverseur (42) configuré pour rendre conducteur le transistor lorsque la tension aux bornes du condensateur du circuit RC est inférieure à un seuil.

2. Interface selon la revendication 1, comprenant en outre :
• une borne de sortie (Tx) conçue pour fournir un signal logique sortant à l'interface distante (IF2) ; et
• un amplificateur (10) connecté pour commander la borne de sortie à partir de la tension d'alimentation auxiliaire.

3. Interface selon la revendication 1, comprenant un empilement de diodes (50) connecté aux bornes du condensateur.

4. Interface selon la revendication 1, comprenant en outre un élévateur de tension (60) configuré pour alimenter le suiveur de tension (16) à une tension (Vddl ') supérieure à la tension d'alimentation de l'interface.

5. Interface selon la revendication 1, comprenant :
• un atténuateur commutable (80) connecté entre la borne d'entrée (Rx) et le discriminateur (12) ; et
• un comparateur (82) connecté pour mettre l'atténuateur en circuit lorsque la tension d'alimentation (Vdd1) de l'interface est inférieure à la valeur crête fournie par le détecteur de crête (Vdd2).

## Patentansprüche

1. Kommunikationsschnittstelle, umfassend:
- eine Eingangsklemme (Rx), die konzipiert ist, um ein logisches Signal einer entfernten Schnittstelle (IF2) zu empfangen;
- einen Logikpegel-Diskriminator (12), der mit der Eingangsklemme gekoppelt ist; einen Spitzendetektor (14), der verbunden ist, um den Spitzenwert des Signals an der Eingangsklemme zu speichern; und
- einen Spannungsfolger (16), der verbunden ist, um dem Diskriminator eine Hilfsversorgungsspannung (Vdd2') bereitzustellen, die auf dem Wert basiert, der durch den Spitzendetektor bereitgestellt wird;
**dadurch gekennzeichnet, dass** sie eine Schutzvorrichtung gegen die elektrostatischen Entladungen umfasst, umfassend:
- eine erste Diode (D1) und einen Schaltkreis RC, der den Spitzendetektor bildet, die in Reihe zwischen der Eingangsklemme (Rx) und einer ersten Versorgungsleitung (Vss1) verbunden sind;
- einen Transistor (MN1), der zwischen der ersten Versorgungsleitung (Vss1) und der Eingangsklemme (Rx) über die erste Diode (D1) oder eine zweite Diode (D1') verbunden ist; und
- einen Umschalter (42), der konfiguriert ist, um den Transistor leitend zu machen, wenn die Spannung an den Klemmen des Kondensators des RC-Schaltkreises kleiner als ein Grenzwert ist.

2. Schnittstelle nach Anspruch 1, darüber hinaus umfassend:
- eine Ausgangsklemme (Tx), die konzipiert ist, um ein zur entfernten Schnittstelle (IF2) ausgehendes logisches Signal bereitzustellen; und
- einen Verstärker (10), der verbunden ist, die Ausgangsklemme ausgehend von der Hilfsversorgungsspannung zu steuern.

3. Schnittstelle nach Anspruch 1, einen Diodenstapel (50) umfassend, der mit den Klemmen des Kondensators verbunden ist.

4. Schnittstelle nach Anspruch 1, darüber hinaus eine Spannungserhöhung (60) umfassend, die konfiguriert ist, um den Spannungsfolger (16) mit einer Spannung (Vdd1') zu versorgen, die höher ist, als die Versorgungsspannung der Schnittstelle.

5. Schnittstelle nach Anspruch 1, umfassend:
- einen schaltbaren Abschwächer (80), der zwischen der Eingangsklemme (Rx) und dem Diskriminator (12) verbunden ist; und
- einen Vergleicher (82), der verbunden ist, um den Abschwächer einzuschalten, wenn die Versorgungsspannung (Vdd1) der Schnittstelle niedriger als der Spitzenwert ist, der von dem Spitzendetektor (Vdd2) bereitgestellt wird.

## Claims

1. A communication interface, comprising:
• an input terminal (Rx) for receiving a logic signal from a remote interface (IF2);
• a logic level discriminator (12) coupled to the input terminal;
• a peak detector (14) connected to store the peak value of the signal at the input terminal; and
• a voltage follower (16) connected to the discriminator for providing an auxiliary supply voltage (Vdd2') based on the value provided by the peak detector;
• an electrostatic discharge (ESD) protection device, including:
∘ a first diode (D1) and an RC-circuit configured as the peak detector, connected in series between the input terminal (Rx) and a first power supply line (Vss1);
∘ a transistor (MN1) connected between the first power supply line (Vss1) and the input terminal (Rx) through the first diode (D1) or a second diode (D1'); and
∘ inverter (42) configured to turn on the transistor when the voltage across the capacitor of the RC-circuit is less than a threshold.

2. The interface of claim 1, further comprising:
• an output terminal (Tx) designed to provide a logical outgoing signal to the remote interface (IF2); and
• an amplifier (10) connected to control the output terminal from the auxiliary supply voltage.

3. The interface of claim 1, comprising a stack of diodes (50) connected across the capacitor.

4. The interface of claim 1, further comprising a voltage elevator (60) configured to supply the voltage follower (16) at a voltage (Vdd1') greater than the supply voltage of the interface.

5. The interface of claim 1 comprising:
• a switchable attenuator (80) connected between the input terminal (Rx) and the discriminator (12); and
• a comparator (82) connected to switch the attenuator into the circuit when the supply voltage (Vdd1) of the interface is less than the peak value supplied by the peak detector (Vdd2).
